# EUROPEAN PATENT APPLICATION

(11) **EP 4 465 412 A1**
(43) Date of publication of application: **20.11.2024**
(21) Application number: 23741579.9
(22) Date of filing: 20.04.2023
(51) Int. Cl.: H01M 10/48

(54) **TEMPERATURE AND VOLTAGE ACQUISITION INTEGRATED MODULE AND BATTERY MODULE**

(30) Priority: 03.04.2023 CN 202310352151; 03.04.2023 CN 202320721358 U
(71) Applicant: Eve Energy Co., Ltd., Huizhou, Guangdong 516006 (CN)
(72) Inventor: LU, Jungao, Huizhou, Guangdong 516006 (CN)
(74) Representative: Petraz, Gilberto Luigi
(86) International application number: PCT/CN2023/089435
(87) International publication number: WO 2024/207555

(57) **Abstract**

Disclosed in the present application is a temperature and voltage acquisition integrated module for acquiring the temperature and voltage of a battery module, including a substrate with thermal and electrical conductivity, connected to a busbar in the battery module; a temperature acquisition circuit, attached to the substrate, insulated and separated from the substrate by an insulating layer, provided with a temperature acquisition pad; a temperature sensor, welded to the temperature acquisition circuit; and a voltage acquisition pad, provided on the substrate and electrically connected to the substrate.

## Description

The present application claims priority of Chinese Patent Application No.2023103 52151.2 filed on April 3, 2023 before CNIPA, and Chinese Patent Application No.202320721358.8 filed on April 3, 2023 before CNIPA. All the above are hereby incorporated by reference in their entirety.

### Field

The present application relates to the technical field of batteries, in particular to a temperature and voltage acquisition integrated module and a battery module.

### Background

With the continuous development of power battery technology, the automation and modularization of encapsulating power battery system have gradually become the mainstream of the development. The battery module in the power battery system is of the most importance. At present, the battery module basically collects the voltage information and temperature information of the battery module through a connector, which transmits the collected status information of the battery module to the battery management system connected with the connector.

A temperature and voltage acquisition method, a temperature and voltage acquisition assembly and a battery module are disclosed in the related art, in which the temperature and voltage acquisition assembly includes a circuit board, a busbar, a first acquisition sheet, a nickel sheet and a temperature sensor; the first acquisition sheet and the nickel sheet are integrated with the busbar; pins of the nickel sheet are connected to the circuit board; the temperature sensor is connected to a protective segment of the first acquisition sheet through a heat conducting pad; the circuit board is connected to the temperature sensor through a first pad; and the circuit board is connected to a nickel layer of the first acquisition sheet through a second pad. However, there are the following problems: based on the installation relationship between the components, when assembling the temperature and voltage acquisition assembly, first the temperature sensor is welded to the first pad, and then the first acquisition sheet is welded to the second pad to cover the temperature sensor by the protective segment. Therefore, the temperature sensor is not integrated with the first acquisition sheet, and the whole temperature and voltage acquisition assembly does not constitute a complete temperature and voltage acquisition module. For battery modules with different specifications, it is necessary to prepare temperature and voltage acquisition assembly with different specifications. For example, if the quantity or size of the battery cell is different, the sizes of the circuit board and the quantity of the busbar should also be adapted to change, which leads to the inability to realize the standardization of the acquisition assembly, and leading to the problems of such as the enhancement of the variety of materials and the amount of production line processes, high production cost and low production efficiency.

Disclosed in the related art is a battery module voltage and temperature acquisition terminal and a battery module, in which the voltage and temperature acquisition terminal of the battery module includes a welding sheet for welding with a busbar; a crimp terminal and an NTC encapsulating housing are provided side by side on an upper part of the welding sheet; the crimp terminal is used to collect a voltage signal; and the NTC encapsulating housing is filled with epoxy resin used to encapsulate an NTC thermistor therein to collect a temperature signal. However, there are the following problems: the heat conducting path is "from the welding sheet - to the epoxy resin - and then to the NTC thermistor". When using epoxy resin to locate the NTC thermistor, the position of the NTC thermistor is difficult to be unified. Therefore, it is necessary to keep a large gap between the NTC thermistor and the inner wall of the NTC encapsulating housing to prevent the NTC thermistor from conducting with the inner wall of the NTC encapsulating body when encapsulating, but the large gap increases the length of the heat conduction path, which leads to lower heat transmitting efficiency, and an inability to effectively and quickly respond to abnormal temperature. Conversely, if the NTC thermistor conducts with the encapsulating body or welding sheet, a temperature-sensitive short circuit may be formed, resulting in the inability to acquire temperature.

Therefore, it is necessary to propose a temperature and voltage acquisition integrated module, which may realize standardization, a short temperature-sensitive heat conducting path, and high performance.

### Summary

In order to overcome at least one of the defects in the prior art mentioned above, provided in the present application is a temperature and voltage acquisition integrated module, which may realize standardization and optimize the heat conducting path by temperature sensing, and improve the performance of the product.

As a first aspect, provided in the embodiment of the present application is a temperature and voltage acquisition integrated module, configured to acquire the temperature and voltage of a battery module, including:
a substrate with thermal and electrical conductivity, connected to a busbar in the battery module;
a temperature acquisition circuit, attached to the substrate, insulated and separated from the substrate by an insulating layer, provided with a temperature acquisition pad;
a temperature sensor, welded to the temperature acquisition circuit; and
a voltage acquisition pad, provided on the substrate and electrically connected to the substrate.

In the temperature and voltage acquisition integrated module provided in the present application, the insulating layer between the temperature acquisition circuit and the substrate plays a role of insulative protection; the temperature sensor is welded on the temperature acquisition circuit; utilizing the thermal conductivity of the substrate, the temperature of the battery cell may be transmitted to the temperature sensor through the substrate and the insulation layer in turn; while utilizing the conductivity of the substrate, the voltage of the battery cell may also be acquired through the substrate, which realizes that the integrated module may be used to acquire temperature and voltage simultaneously, and realize the standardization of the integrated module, effectively reduce the manufacturing process and material types, optimize the role of the temperature-sensitive heat conducting path, and the product performance is improved, and addressing the technical problems of a long heat conducting path, low heat conducting efficiency, and inability to effectively and quickly respond to abnormal temperatures in the prior art.

The standardization of the temperature and voltage acquisition module is embodied as follows: when it is applied to a battery module of any specification, a corresponding quantity of temperature and voltage acquisition module may be adopted; the substrate may be connected to the busbar in the battery module; and the temperature acquisition pads and voltage acquisition pads may be welded to the acquisition wire to transmit the temperature information and voltage information to the battery management system.

In some implementations, the temperature acquisition circuit, the temperature sensor and the voltage acquisition pad are located on a first side wall of the substrate, and facilitate the manufacture of the temperature and voltage acquisition integrated module.

In some implementations, there are two temperature acquisition pads; the voltage acquisition pad and the two the temperature acquisition pads are spaced apart on a same side of the temperature sensor, and facilitate the welding between the acquisition wires and the pads.

In some implementations, the substrate is provided with at least one through-hole, in which the through-hole is located between the two temperature acquisition pads and/or between the voltage acquisition pad and the temperature acquisition pads, and separate the pads by the through-hole.

In some implementations, the through-hole is an oblong hole; two ends of the through-hole in a length direction protrude from two ends of the temperature acquisition pad or two ends of the voltage acquisition pad.

In some implementations, the temperature and voltage acquisition integrated module further includes a protective cover provided on the substrate and covering the temperature sensor; the temperature acquisition pad and the voltage acquisition pad are located outside of the protective cover.

In some implementations, the protective cover is filled with protective plastic wrapped around the temperature sensor, and a side wall of the protective cover away from the substrate is provided with an opening for glue injection. In such a setup, the protective plastic is injected through the opening of the protective cover to wrap the temperature sensor. The protective cover may avoid external impact and fix the shape of the protective plastic. The protective plastic may avoid water vapor and foreign matters with electrical conductivity, and ensure the normal operation of the temperature sensor.

In some implementations, the temperature sensor is an NTC thermistor.

As a second aspect, provided in the embodiment of the present application is a battery module, including a battery cell, a busbar and the temperature and voltage acquisition integrated module mentioned above; the battery cell is connected to the busbar; and a substrate of the temperature and voltage acquisition integrated module is welded to the busbar.

In some implementations, a concave welding position is provided on the busbar, and a second side wall of the substrate abuts and is welded to the welding position. In such a setup, the temperature and voltage acquisition integrated module is located on the concave welding position, and store the temperature and voltage acquisition integrated module, which prevents the temperature and voltage acquisition integrated module from exposing, or which reduces the exposed height of the temperature and voltage acquisition integrated module, and reducing the risk of shock to the temperature sensor.

In summary, the temperature and voltage acquisition integrated module provided in the present application provides technical effects as follows:

standardization may be achieved: the substrate may be connected to the busbar of the battery module by welding, threaded connection or other manners. The temperature and voltage transmission is achieved by utilizing the thermal and conductive properties of the substrate, and the temperature acquisition circuit and temperature sensor are protected by an insulating layer to avoid a short circuit. When the integrated module is applied to a battery module of any specification, the integrated module may be used to collect temperature and voltage simultaneously, which enables the standardization of the integrated module and the effective reduction of the manufacturing process and material types.

short temperature-sensitive heat conducting path and good performance of the product: the heat conducting path is "from the substrate - to the insulating layer - and then to the temperature sensor"; the electrical conducting path is "from the substrate - to the voltage acquisition pad"; the insulating layer is relatively thin, and the influence on the heat conducting distance and efficiency may be basically ignored; and adopting the temperature acquisition circuit to increase the temperature acquisition area of the substrate, which effectively shortens the heat conducting path and improves the heat transmitting efficiency, and effectively and quickly responding to the presence of abnormal temperature and greatly improving the product performance of the integrated module.

high safety: a protective cover incorporating protective plastic is provided to prevent possible temperature sensor failure under various conditions; in the battery module, concave welding positions on the busbar are utilized to install the temperature and voltage acquisition integrated module, and reducing the risk of impact to the temperature sensor.

### Brief description of the drawings

Fig. 1 is a perspective structural diagram of the temperature and voltage acquisition integrated module in some embodiments of the present application;
Fig. 2 is a front view of the temperature and voltage acquisition integrated module in some embodiments of the present application;
Fig. 3 is an exploded view of the temperature and voltage acquisition integrated module in some embodiments of the present application;
Fig. 4 is a perspective structural diagram of the temperature and voltage acquisition integrated module connected to the busbar in some embodiments of the present application.

The meanings of the attached markings are as follows:
1 temperature and voltage acquisition integrated module; 11 substrate; 111 through-hole; 112 connecting hole; 12 temperature acquisition circuit; 121 temperature acquisition pad; 122 temperature-sensitive welded joint; 13 insulating layer; 14 temperature sensor; 15 voltage acquisition pad; 16 protective cover; 161 opening; 162 connecting joint; 2 busbar; 21 welding position.

### Detailed description

In the description of the present application, it is to be noted that the terms "up", "down", "front", "back", "left", "right", "vertical", "horizontal", "top", "bottom", "inside", "outside" and other orientation or position relationships are based on the orientation or position relationships shown in the attached drawings. It is only intended to facilitate description and simplify operation, but not to indicate or imply that the referred device or element has a specific orientation, or is constructed and operated in a specific orientation. Therefore, they should not be construed as a limitation of the present application.

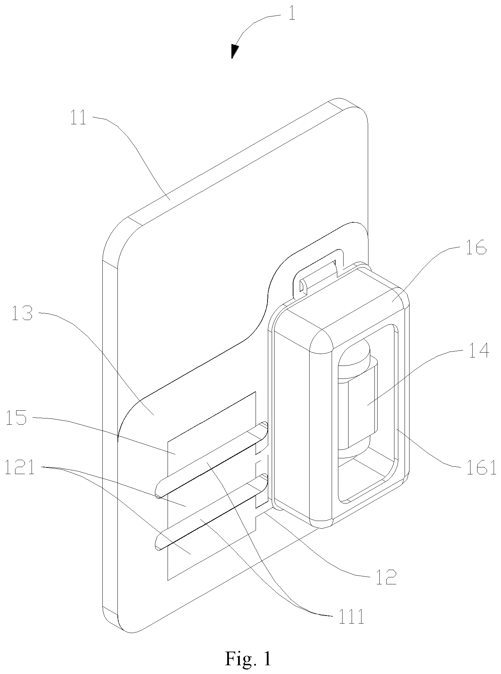

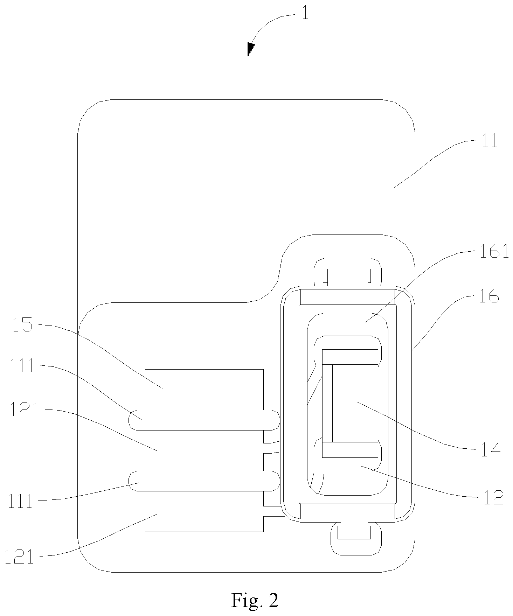

Referring to Fig. 1 and Fig. 2, disclosed in the present application is a temperature and voltage acquisition integrated module 1, provided for acquiring the temperature and voltage of the battery module, including a substrate 11, a temperature acquisition circuit 12, an insulating layer 13, a temperature sensor 14, a voltage acquisition pad 15 and a protective cover 16.

In the present embodiment, the substrate 11 serves as a main carrier to carry the other components, and the substrate 11 also has thermal and conductive properties for connecting with the bus bar 2 in the battery module, and transmitting the temperature and voltage of the battery cell. As an example, the substrate 11 may be a metal board, preferably an aluminum board or a copper board. Admittedly, in the other preferred example, the substrate 11 may further be made of graphene composites, as long as to possess the thermal and electrical conductivity and possess certain load-carrying capacity.

Preferably, the substrate 11 is a rectangular or square aluminum board; a thickness of the substrate 11 is between 0.2 mm and 3 mm; a length of one side of the substrate 11 is between 8 mm and 25 mm; and a length of another side of the substrate 11 is between 6 mm and 20 mm. Further and preferably, a thickness of the substrate 11 is between 0.5 mm and 1 mm; a length of one side of the substrate 11 is between 10 mm and 16 mm; and a length of another side of the substrate 11 is between 8 mm and 12 mm.

Admittedly, the substrate 11 may also be diamond-shaped, pentagonal or hexagonal, etc. The specific shape of the substrate 11 is not limited in the present application.

In the present embodiment, the temperature acquisition circuit 12 is attached to the substrate 11. The temperature sensor 14 is welded to the temperature acquisition circuit 12, and relatively fix the temperature sensor 14 on the substrate 11 through the temperature acquisition circuit 12. Additionally, the temperature acquisition circuit 12 is insulated and separated from the substrate 11 by an insulating layer 13, which prevents the temperature acquisition circuit 12 from conducting to the substrate 11, and avoids the temperature-sensitive short circuit leading by conducting the temperature sensor 14 with the substrate 11, and providing insulation protection. The temperature acquisition circuit 12 has a temperature acquisition pad 121 used to weld with the acquisition wires, and transmit the temperature information to the battery management system.

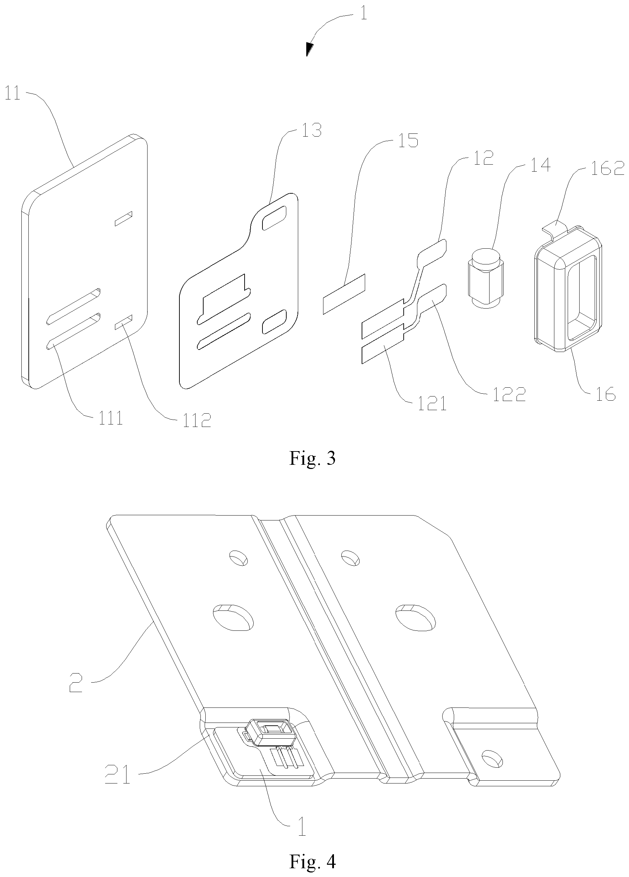

In combination with Fig. 3, specifically, the temperature acquisition circuit 12 includes two sub-circuits corresponding to two ends of the temperature sensor 14 respectively. Two sub-circuits are spaced apart; each sub-circuit includes a temperature acquisition pad 121 and a temperature-sensitive welded joint 122 both connected to each sub-circuit; and two ends of the temperature sensor 14 are welded to two temperature-sensitive welded joints 122 respectively.

As an example, the insulating layer 13 may be applied to the surface of the substrate 11, or the insulating layer 13 may also be adhered to the surface of the substrate 11. The temperature acquisition circuit 12 may be made of copper foil, aluminum foil, nickel foil, tin foil or lead foil, etc. Preferably, the temperature acquisition circuit made of copper foil may be adhered to a surface of the insulating layer 13 away from the substrate 11. In the other example, the temperature acquisition circuit 12 may also be made of other metal foil or metal sheets, and the temperature acquisition circuit 12 may also be partially fused in the insulating layer 13.

Preferably, the thickness of the insulating layer 13 is between 0.01 mm and 1 mm; the insulating layer 13 may fully cover any one of the surfaces of the substrate 11; the insulating layer 13 may also partially cover one of the surfaces of the substrate 11, as long as to satisfy the insulation and separation of the temperature acquisition circuit 12 and the temperature sensor 14; and the thickness of the temperature acquisition circuit 12 is between 0.01 mm and 1 mm.

Preferably, the temperature sensor 14 is an NTC thermistor, and detects tiny temperature differences sensitively. When the temperature transmitted to the NTC thermistor changes, the resistance of the NTC thermistor also changes, and identifying the temperature change by the change in the resistance of the NTC thermistor. Admittedly, the temperature sensor 14 may be a PTC thermistor or other thermistor.

In the present embodiment, a voltage acquisition pad 15 is provided on the substrate 11 and electrically connected to the substrate 11; the voltage acquisition pad 15 may also be used to weld with the acquisition wires, and transmit the voltage information to the battery management system. As an example, a voltage acquisition pad 15 may be attached to the substrate 11, and a special process is adopted to realize the electrical conductivity between the voltage acquisition pad 15 and the substrate 11. For example, the voltage acquisition pad 15 may be made of metal foil or metal sheet (such as copper, nickel, aluminum, or lead), which abuts and is welded to the substrate 11; or molten metal liquid (such as copper, nickel, tin, aluminum or lead) is applied to the substrate 11 and solidified to form the voltage acquisition pad 15. As another example, the voltage acquisition pad 15 may also be an exposed welding position belonging to the substrate 11 itself. The specific connection between the voltage acquisition pad 15 and the substrate 11, or forming manner of the voltage acquisition pad 15 is not limited in the present application.

It is to be understood that, in order to prevent the insulating layer 13 from influencing the electrical conductivity of the voltage acquisition pad 15, the insulating layer 13 is formed at the position corresponding to the voltage acquisition pad 15 with an avoiding hole, in which the avoiding hole is adapted to the shape and size of the voltage acquisition pad 15.

In the temperature and voltage acquisition integrated module 1 of the solution mentioned above, the insulating layer 13 between the temperature acquisition circuit 12 and the substrate 11 plays a role of insulative protection; the temperature sensor 14 is welded on the temperature acquisition circuit 12; the temperature information may be acquired by the temperature sensor 14, and the voltage information may be acquired by the substrate 11; the temperature information and voltage information may be outputted by the temperature acquisition pad 121 and the voltage acquisition pad 15, which realizes that the integrated module is used to acquire the temperature and the voltage simultaneously, and reducing the manufacturing process and the material types; also, in the temperature and voltage acquisition integrated module 1, the thermal conductivity path is "substrate 11 - insulating layer 13 - temperature sensor 14"; the electrical conductivity path is "substrate 11 - voltage acquisition pad 15"; the insulating layer is relatively thin, and the influence on the heat conducting distance and efficiency may be basically ignored; adopting the temperature acquisition circuit 12 to increase the temperature acquisition area of the substrate 11, which effectively shortens the heat conducting path and improves the heat transmitting efficiency, and effectively and quickly responding to the presence of abnormal temperature and greatly improving the product performance of the integrated module.

Referring to Fig. 1, in the present embodiment, a protective cover 16 is provided on the substrate 11, covering the temperature sensor 14; the temperature acquisition pad 121 and the voltage acquisition pad 15 are located outside of the protective cover 16. Preferably, the protective cover 16 is filled with protective plastic (not shown in the figure) wrapped around the temperature sensor 14, and a side wall of the protective cover 16 away from the substrate 11 is provided with an opening 161 for glue injection. The protective cover 16 may play a role as follows: preventing the external impulsive force from directly acting on the temperature sensor 14 to cause failure; used to secure the shape of the protective plastic. The protective plastic may play a role as follows: preventing foreign objects with electrical conductivity from falling into the protective cover 16 and conducting the temperature-sensitive welded joint 122, which may lead to failure of the temperature sensor 14; preventing water vapor from invading inside the temperature sensor 14, and result in failure; force cushioning, which may absorb the impact imposed on the protective cover 16, and prevent the protective cover 16 from deformation leading to failure of the temperature sensor 14.

In conjunction with Fig. 3, in order to facilitate the installation of the protective cover 16 on the substrate 11, as an example, the protective cover 16 is provided with connecting joints 162 at each lengthwise end of the protective cover 16; the substrate 11 is provided with connecting holes 112 corresponding to the connecting joints 162; when installing, the connecting joints 162 are inserted into the connecting holes 112, in which the connecting holes 112 may be fastened by bending the connecting joints 162, and complete the installation of the protective cover 16 on the substrate 11. Admittedly, in the other example, the protective cover 16 may be mounted on the substrate 11 in other manners. The installation of the protective cover 16 is not specifically limited in the present application.

Preferably, the protective cover 16 may be made of metal, and ensure that it possesses enough connecting strength and anti-impact strength. Admittedly, the protective cover 16 may also be made of plastic or other materials.

Preferably, the substrate 11 has a first side wall and a second side wall on opposite sides. The temperature acquisition circuit 12, the insulating layer 13, the temperature sensor 14, the voltage acquisition pad 15, and the protective cover 16 are located on the first side wall of the substrate 11, and facilitate the manufacture of the temperature and voltage acquisition integrated module 1.

Referring to Fig. 2, in the present embodiment, the voltage acquisition pad 15 and two temperature acquisition pads 121 are spaced apart on the same side of the temperature sensor 14. Referring to the orientation shown in Figure 2, specifically, the voltage acquisition pad 15 and two temperature acquisition pads 121 are both located on the left side of the temperature sensor 14 and the protective cover 16, and the voltage acquisition pad 15 and two temperature acquisition pads 121 are sequentially arranged from top to bottom.

Preferably, the distance between the voltage acquisition pad 15 and the temperature acquisition pad 121, and the distance between two temperature acquisition pads 121 are both larger than 0.3 mm; more preferably, the distances are larger than 0.5 mm; the voltage acquisition pad 15 and the temperature acquisition pads 121 are rectangular in shape, whose length is between 2 mm and 5 mm, whose width is between 0.8 mm and 2 mm; more preferably, the length thereof is between 3 mm and 4 mm, and the width thereof is between 1 mm and 1.5 mm.

Referring to Fig. 2 and Fig. 3, in the present embodiment, more importantly, the substrate 11 is provided with two through-holes 111; one through-hole 111 is located between two temperature acquisition pads 121; another through-hole 111 is located between the voltage acquisition pad 15 and the temperature acquisition pad 121, and separate the pads by the through-hole 111, and avoiding conduction between welds when welding the acquisition wires, which also facilitate the cleaning of exposed welds.

Admittedly, the specific quantity of the through-holes 111 may vary based on requirements. For example, there may be only one through-hole 111, which is located between the two temperature acquisition pads 121, or between the voltage acquisition pad 15 and the temperature acquisition pad 121.

Specifically, the through-hole 111 is an oblong hole; two ends of the through-hole 111 in a length direction protrude from two ends of the temperature acquisition pad 121 or two ends of the voltage acquisition pad 15, and better separate the pads.

Referring to Fig. 4, based on the same idea, in the present embodiment, disclosed in the present application is a battery module, including a temperature and voltage acquisition integrated module 1, a busbar 2 and a battery cell (not shown in the figure); the battery cell is connected to the busbar 2; and a substrate 11 of the temperature and voltage acquisition integrated module 1 is welded to the busbar 2.

According to the solutions mentioned above, when applying the temperature and voltage acquisition integrated module 1 to a battery module of any specification, the corresponding quantity of temperature and voltage acquisition integrated module 1 is adopted and the substrate 11 is welded to the busbar 2 in the battery module, and the temperature acquisition pads 121 and voltage acquisition pads 15 may be welded to the acquisition wires to transmit the temperature information and voltage information to the battery management system.

It is to be understood that the acquisition wire may be a wire harness or an FPC connector to enable the information to be delivered outward.

Specifically, the busbar 2 is used to connect two adjacent battery cells in series with each other; a concave welding position 21 is provided on the busbar 2; and the second side wall of the substrate 11 abuts and is welded to the welding position 21. In such a setup, the temperature and voltage acquisition integrated module 1 is located on the concave welding position 21, and stores the temperature and voltage acquisition integrated module 1, which prevents the temperature and voltage acquisition integrated module 1 from exposing, or which reduces the exposed height of the temperature and voltage acquisition integrated module 1, and reducing the risk of shock to the temperature sensor 14.

Admittedly, in the other embodiment, one edge of the substrate 11 may be welded to one edge of the busbar 2.

In summary, referring to Fig. 3, the manufacturing process of the temperature and voltage acquisition integrated module 1 provided in the present application may be as follows:
cutting out the substrate 11 in the corresponding shape and for each hole position according to the design requirements;
welding the voltage acquisition pad to the corresponding position of the substrate 11;
applying an insulating layer 13 to a preset area on the first side wall of the substrate 11; adhering the temperature acquisition circuit 12 to the insulating layer 13 in a state where the insulating layer 13 is half dry or fully dry; keeping the temperature acquisition circuit 12 at a corresponding position on the substrate 11;
after the temperature acquisition circuit 12 is fixed, welding the temperature sensor 14 to the temperature-sensitive welded joint 122 of the temperature acquisition circuit 12;
inserting the connecting joints 162 of the protective cover 16 into the connecting holes 112; mounting the protective cover 16 on the substrate 11 by coupling the connecting joints 162 with the connecting holes 112;
and completing the overall production of the temperature and voltage acquisition integrated module 1 by injecting protective plastic through the opening 161 of the protective cover 16.

In summary, referring to Fig. 1 and Fig. 4, the working process of the temperature and voltage acquisition integrated module 1 and the battery module in the present application is as follows:

The heat of the battery cell may all be transferred to the busbar 2 and then transferred to the substrate 11 through the bonding surface of the busbar 2 and the substrate 11. The heat of the substrate 11 is radiated to the temperature acquisition circuit 12 and the temperature sensor 14 through the insulating layer 13; the resistance of the temperature sensor 14 changes after being heated, and the temperature of the battery cell is acquired, and the temperature signal is transmitted to the battery management system sequentially through the temperature acquisition pad 121 and the acquisition wires; and

the voltage of the battery cell may be conducted to the busbar 2 and the substrate 11, so that the voltage of the battery cell is acquired, and the voltage signal is transmitted from the voltage acquisition pad 15 and the acquisition wires to the battery management system.

In summary, the temperature and voltage acquisition integrated module 1 provided in the present application provides technical effects as follows:
standardization may be achieved: the insulating layer 13 between the temperature acquisition circuit 12 and the substrate 11 plays a role of insulative protection; the temperature sensor 14 is welded on the temperature acquisition circuit 12; the temperature information may be acquired by the temperature sensor 14, and the voltage information may be acquired by the substrate 11; the temperature information and voltage information may be outputted by the temperature acquisition pad 121 and the voltage acquisition pad 15, which realizes that the integrated module is used to acquire the temperature and the voltage simultaneously, and reducing the manufacturing process and the material types;
short temperature-sensitive heat conducting path and good performance of the product: the heat conducting path is "from the substrate 11 - to the insulating layer 13 - and then to the temperature sensor 14"; the electrical conductivity path is "from the substrate 11 - to the voltage acquisition pad 15"; the insulating layer 13 is relatively thin, and the influence on the heat conducting distance and efficiency may be basically ignored; adopting the temperature acquisition circuit 12 to increase the temperature acquisition area of the substrate 11, which effectively shortens the heat conducting path and improves the heat conducting efficiency, and effectively and quickly responding to the presence of abnormal temperature and greatly improving the product performance of the integrated module;
high safety: a protective cover 16 incorporating protective plastic is provided to prevent possible temperature sensor 14 failure under various conditions; concave welding positions 21 on the busbar 2 in the battery module are utilized to install the temperature and voltage acquisition integrated module 1, and reducing the risk of impact to the temperature sensor 14.

## Claims

1. A temperature and voltage acquisition integrated module, configured to acquire a temperature and a voltage of a battery module, **characterized by** comprising:
a substrate (11) with thermal and electrical conductivity, connected to a busbar (2) in the battery module;
a temperature acquisition circuit (12), attached to the substrate (11), insulated and separated from the substrate (11) by an insulating layer (13), provided with a temperature acquisition pad (121);
a temperature sensor (14), welded to the temperature acquisition circuit (12); and
a voltage acquisition pad (15), provided on the substrate (11) and electrically connected to the substrate (11).

2. The temperature and voltage acquisition integrated module according to claim 1, wherein the temperature acquisition circuit (12), the temperature sensor (14) and the voltage acquisition pad (15) are located on a first side wall of the substrate (11).

3. The temperature and voltage acquisition integrated module according to claim 2, wherein there are two temperature acquisition pads (121); the voltage acquisition pad (15) and the two temperature acquisition pads (121) are spaced apart on a same side of the temperature sensor (14).

4. The temperature and voltage acquisition integrated module according to claim 3, wherein the substrate (11) is provided with at least one through-hole (111), the through-hole (111) is located between the two temperature acquisition pads (121) and/or between the voltage acquisition pad (15) and the temperature acquisition pads (121).

5. The temperature and voltage acquisition integrated module according to claim 4, wherein the through-hole (111) is an oblong hole; two ends of the through-hole (111) in a length direction protrude from two ends of the temperature acquisition pad (121) or two ends of the voltage acquisition pad (15).

6. The temperature and voltage acquisition integrated module according to claim 1, further comprising a protective cover (16), provided on the substrate (11), covering the temperature sensor (14); the temperature acquisition pad (121) and the voltage acquisition pad (15) are located outside of the protective cover (16).

7. The temperature and voltage acquisition integrated module according to claim 6, wherein the protective cover (16) is filled with protective plastic wrapped around the temperature sensor (14), and a side wall of the protective cover (16) away from the substrate (11) is provided with an opening (161) for glue injection.

8. The temperature and voltage acquisition integrated module according to claim 1, wherein the temperature sensor (14) is an NTC thermistor.

9. A battery module, comprising a battery cell, a busbar (2) and the temperature and voltage acquisition integrated module as claimed in any one of claims 1-8; the battery cell is connected to the busbar (2); and a substrate (11) of the temperature and voltage acquisition integrated module is welded to the busbar (2).

10. The battery module according to claim 9, wherein a concave welding position (21) is provided on the busbar (2), and a second side wall of the substrate (11) abuts and is welded to the welding position (21).
